# Europäisches Patentamt

# European Patent Office

# Office européen des brevets

(19)

(11) Veröffentlichungsnummer: **0 103 888**
**B1**

(12) ## EUROPÄISCHE PATENTSCHRIFT

(45) Veröffentlichungstag der Patentschrift:
**10.05.89**

(21) Anmeldenummer: **83109337.2**

(22) Anmeldetag: **20.09.83**

(51) Int. Cl.⁴: **H 01 L 23/56,** H 01 L 23/48

(54) **Verfahren und Vorrichtung zum Schützen von filmmontierten integrierten Schaltkreisen (Mikropacks) vor Zerstörung durch elektrostatische Aufladung.**

(30) Priorität: **20.09.82 DE 3234745**

(43) Veröffentlichungstag der Anmeldung:
**28.03.84 Patentblatt 84/13**

(45) Bekanntmachung des Hinweises auf die Patenterteilung:
**10.05.89 Patentblatt 89/19**

(84) Benannte Vertragsstaaten:
**AT BE CH DE FR GB IT LI NL**

(56) Entgegenhaltungen:
**DE-A-3 035 125**
**DE-C-3 207 458**
**GB-A-1 326 437**
**US-A-3 746 157**
**US-A-3 823 350**
**US-A-4 007 479**
**US-A-4 069 496**

(73) Patentinhaber: **Siemens Aktiengesellschaft Berlin und München, Wittelsbacherplatz 2, D-8000 München 2 (DE)**

(72) Erfinder: **Fritz, Otmar, Dipl.- Ing., Johann- Hackl- Ring 64, D-8011 Neukeferloh (DE)**

LIBER, STOCKHOLM 1989

EP 0 103 888 B1

## Beschreibung

Die Erfindung bezieht sich auf eine Trägervorrichtung für filmmontierte integrierte Schaltkreise nach dem Oberbegriff des Patentanspruchs 1 sowie auf ein Verfahren zur Handhabung derselben nach dem Oberbegriff des Patentanspruchs 7.

Die Empfindlichkeit von integrierten Schaltkreisen in MOS-Technologie gegenüber elektrostatischer Aufladung ist bekannt. Eine solche elektrostatische Aufladung kann beim Hantieren der Schaltkreise selbst bzw. der Baugruppen, die mit diesen Schaltkreisen bestückt sind, verursacht werden und zur Zerstörung der Schaltkreise führen. Aber auch bei Schaltkreisen, die in einer anderen Technologie aufgebaut sind, ist eine Gefährdung der Schaltkreise nicht ausgeschlossen. Sie nimmt mit zunehmender Integrationsdichte dieser Schaltkreise an Bedeutung zu. In Zukunft ist deshalb einer genereller Schutz von integrierten Schaltkreisen gegen elektrostatische Aufladung erforderlich. Dies gilt in besonderem Maße für Schaltkreise, die auf einem Filmtäger montiert und als Mikropacks gehandhabt und verarbeitet werden.

Aus dem US-Patent 4 069 496 ist es bekannt, zum Schutze eines filmmontierten integrierten Schaltkreises vor mechanischer Beschädigung diesen in einen einteiligen Halterahmen einzulegen, der in seinen Außenabmessungen den in der Fototechnik üblichen Diarahmen entspricht. Der Halterahmen weist ein zentrales Fenster auf, durch das die Rückseite des integrierten Schaltkreises zugänglich ist. An der Oberseite des Halterahmens sind Haltenasen angeordnet, die in die Perforation des Filmes eingreifen. In einem solchen Halterahmen ist ein filmmontierter Schaltkreis zwar vor mechanischer Beschädigung geschützt, nicht aber vor Zerstörung durch elektrostatische Aufladung.

Aus dem US-Patent 3 746 257 ist es bekannt, zur mechanisch und elektrostatisch geschützten Aufbewahrung eines in einem Gehäuse befindlichen integrierten Schaltkreises das Gehäuse zwischen einem Tragekörper und einer auf den Tragekörper einrastbaren Kappe zu fixieren. Die Anschlußdrähte des integrierten Schaltkreises sind über elektrisch leitfähig ausgebildete Kanten der Kappe untereinander kurzgeschlossen und können zu Prüfzwecken ohne Entfernen der Kappe von den Kanten abgehoben werden.

Die übliche Methode, integrierte Schaltkreise gegen elektrostatische Aufladung zu schützen, besteht nämlich darin, diese kurzzuschließen bzw. zu erden. So ist es zum Beispiel bei filmmontierten Schaltkreisen bekannt, die Leiterbahnanschlüsse der Schaltkreise über den äußeren Kontaktierbereich hinaus zu verlängern und in einem oder mehreren Kurzschlußpunkten zusammenzufassen und diese wiederum an eine auf der gesamten Filmlänge durchlaufenden Erdungsschiene anzuschließen.

Für die elektrische Prüfung eines integrierten Schaltkreises müssen die Anschlüsse aufgetrennt werden und nach der Prüfung für die weitere Handhabung wieder an die Erdungsschiene angeschlossen werden. Dies kann zum Beispiel dadurch geschehen, daß die Kurzschlußpunkte ausgeschnitten und nach dem Prüfen zum Beispiel mit einem Lotniet wieder verschlossen werden. Diese Methode fordert wegen der geringen Abmessungen der ausgeschnittenen Kurzschlußpunkte ein hochpräzises Arbeiten beim Wiederverschließen und ist in der Regel nur manuell durchführbar. Es ist deshalb auch bereits vorgeschlagen worden, die Leiterbahnanschlüsse der integrierten Schaltkreise derart auszubilden, daß in der Leiterbahn zwischen dem Kurzschlußpunkt und der Erdschiene eine beide miteinander verbindende leitende Fläche vorgesehen ist, die an zwei Seiten von dieser getrennt und über einen Ausschnitt im Film angeordnet und so dimensioniert ist, daß sie nach dem Aufschneiden der dritten Seite über die vierte Seite so umklappbar ist, daß sie alle zu dem Kurzschlußpunkt führenden Leiter bedeckt. Diese Maßnahme führt zwar bereits zu sehr guten Ergebnissen, ist aber überall dort nicht anwendbar, wo wegen der Vielzahl der Anschlüsse des integrierten Schaltkreises kein Platz mehr Vorhanden ist für die Unterbrechung einer solchen Fläche.

Der Erfindung lag daher die Aufgabe zugrunde, eine Trägervorrichtung nach dem Oberbegriff des Patentanspruchs 1 mit einer elektrostatischen Schutz bietenden Anordnung anzugeben.

Außerdem ist es die Aufgabe der Erfindung unter Verwendung einer Trägervorrichtung nach dem Oberbegriff des Patentanspruchs 1 ein Verfahren anzugeben, das die Handhabung von filmmontierten integrierten Schaltkreisen, deren äußere Leiterbahnanschlüsse über ihren jeweiligen Kontaktierbereich hinaus verlängert und in einem oder mehreren Kurzschlußpunkten zusmmengefaßt sind, so vereinfacht, daß auch eine solche Art von filmmontierten integrierten Schaltkreisen unmittelbar nach dem Abtrennen vom Filmband in die Trägervorrichtung eingelegt werden und bis zur abschließenden Montage darin fixiert bleiben können.

Gelöst wird der erste Teil der Aufgabe durch die Merkmale des kennzeichnenden Teils des Patentanspruchs 1. Der zweite Teil der Aufgabe wird durch die Merkmale des kennzeichnenden Teils des Patentanspruchs 7 gelöst.

Durch die Erfindung ist es möglich, unter Vermeidung schwierig durchzuführenden Arbeiten an den einzelnen Leiterbahnanschlüssen oder den Kurzschlußpunkten des Mikropacks und auch bei Mikropacks mit einer sehr großen Anzahl von Anschlüssen, einen ausgezeichneten Schutz vor Zerstörung durch elektrostatische Aufladung zu erreichen. Außerdem ist es von Vorteil, daß die Mikropacks bis zur endgültigen Montage geschützt bleiben und erst danach durch einen ganz einfachen Handgriff von der Schutzvorrichtung befreit werden können. Zudem ist es von Vorteil, daß die erfindungsgemäße Vorrichtung jederzeit wieder verwendet werden kann.

Weitere Einzelheiten der Erfindung ergeben sich aus der nachfolgenden Beschreibung einiger vorteilhafter Ausführungsbeispiele der erfindungsgemäßen Vorrichtung anhand der Figuren 1 bis 6, wobei

Fig. 1 einen durch eine Kurzschlußleiterbahn geschützten filmmontierten integrierten Schaltkreis zeigt,

Fig. 2 ein Ausführungsbeispiel für den erfindungsgemäßen Halterahmen zeigt,

Fig. 3 die gegenseitige Lage von Halterahmen, Kurzschlußrahmen und Mikropack zeigt,

Fig. 4 eine vorteilhafte Ausgestaltung und die Lage von ringförmigen leitenden Kurzschlußelementen zeigt,

Fig. 5 einen nicht durch eine Kurzschlußleiterkonfiguration geschützten integrierten filmmontierten Schaltkreis zeigt, und

Fig. 6 Lage und Ausgestaltung von streifen- oder rahmenförmigen leitenden Kurzschlußelementen zeigt.

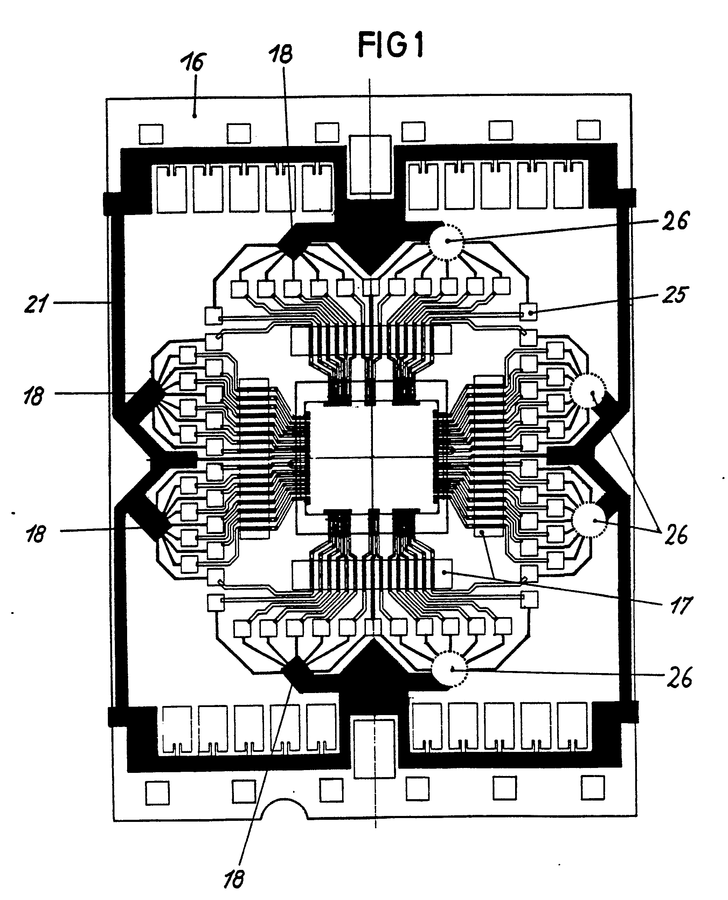

Figur 1 zeigt einen filmmontierten integrierten Schaltkreis (Mikropack) 16, bei dem die äußeren Leiterbahnanschlüsse des im Zentrum des Mikropacks angeordneten integrierten Schaltkreises über ihren äußeren Kontaktierbereich 17 hinaus verlängert und in Kurzschlußpunkten 18 zusammengefaßt sind. Diese Kurzschlußpunkte 18 sind untereinander durch eine Kurzschlußleiterbahn 21 miteinander verbunden, über die sie außerdem geerdet werden können. Zur elektrischen Prüfung des integrierten Schaltkreises im Mikropack 16 müssen die äußeren Leiterbahnanschlüsse 17 bzw. die Prüfpunkte 25 von der Leiterbahn 21 getrennt werden. Dies geschieht z. B. durch Ausstanzen der Kurzschlußpunkte 18, wie es mit dem Bezugszeichen 26 angedeutet ist.

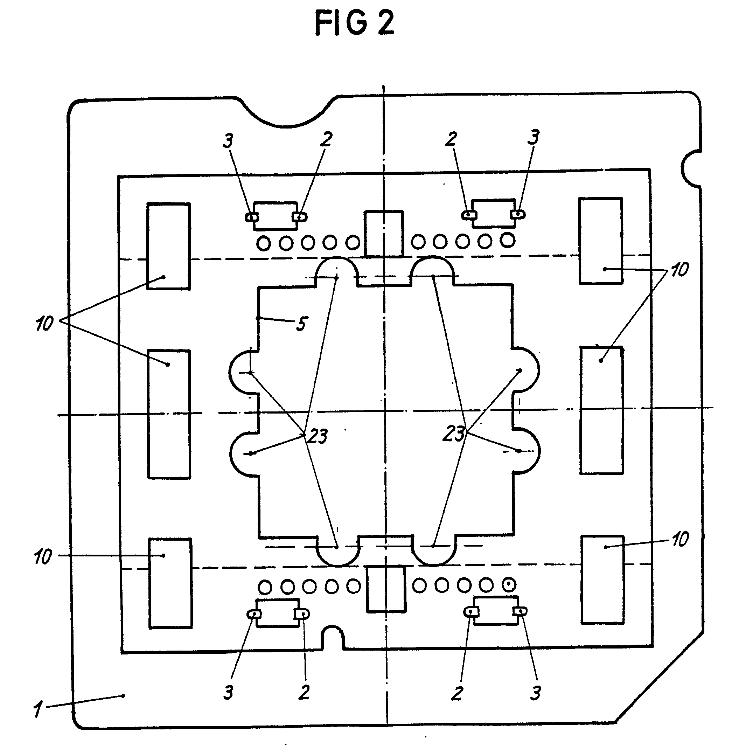

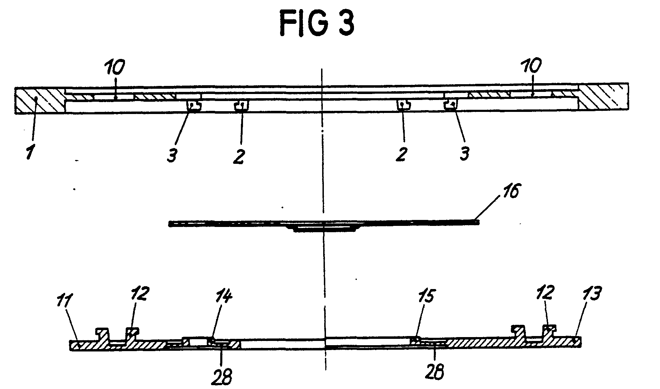

Figur 2 zeigt ein Ausführungsbeispiel für einen Halterahmen 1, der in seinen äußeren Abmessungen im wesentlichen den in der Fototechnik üblichen Diarahmen entspricht. In seinem Inneren ist ein zentrales Fenster 5 zum frei zugänglichen Lagern des zu bearbeitenden Mikropacks 16 vorgesehen. Weiterhin hat er verteilt z. B. an zwei Seiten des Rahmens Haltenasen 2, 3, die in die Perforation des Mikropacks 16 eingreifen und seitliche Lage sowie Planlage des Mikropacks innerhalb des Rahmens 1 fixieren. Weiter ist ersichtlich, daß der Halterahmen 1 eine Reihe von verteilt angeordneten Ausnehmungen 10 besitzt. In diese greifen, wie Figur 3 zeigt, Verschließnoppen 12 ein, die auf der einen Seite eines Kurzschlußrahmens 11, 13 angeordnet sind. Außerdem sind Ausnehmungen 23 vorgesehen, die dazu dienen, die Kurzschlußpunkte 18 des Mikropacks 16 auch dann ausstanzen zu können, wenn es im Halterahmen 1 liegt.

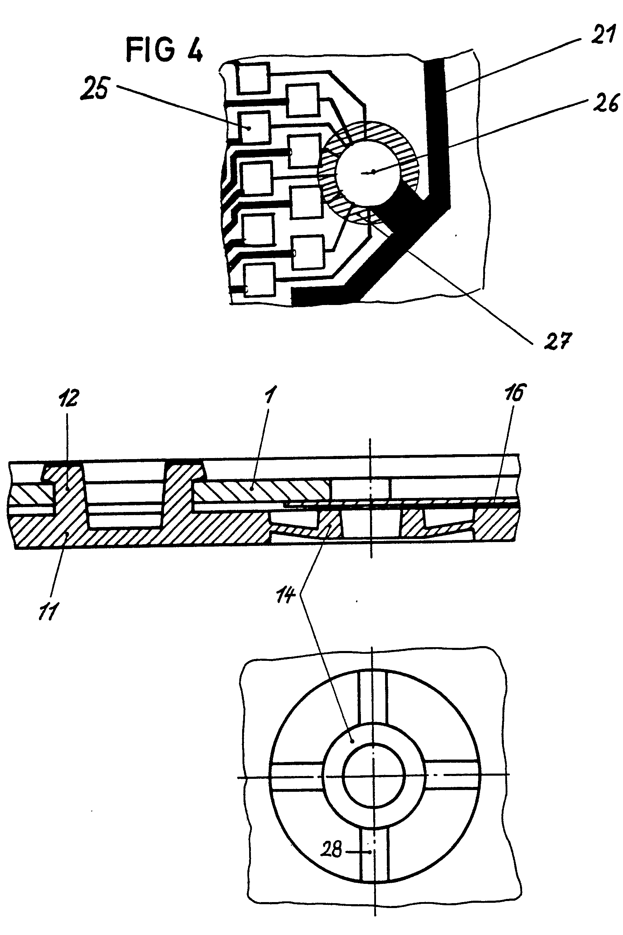

Der untere Teil von Figur 3 zeigt links und rechts von der Symmetrielinie zwei verschiedene Ausführungsbeispiele für einen Kurzschlußrahmen 11, 13. Das wesentliche dieses Kurzschlußrahmens 11, 13 ist, daß er ein oder mehrere über den Kurzschlußpunkten 18 des Mirkopacks 16 bzw. den äußeren Leiterbahnanschlüssen zu liegen kommende leitende Elemente 14, 15 besitzt, die über Stege oder Membranen 28 mit dem Körper des Kurzschlußrahmens 11, 13 verbunden sind. Durch das Einschnappen des Kurzschlußrahmens 11, 13 in den Halterahmen 1 mit Hilfe der Verschließnoppen 12 werden die leitenden Elemente 14, 15 definiert, z. B. an die Bereiche 27 um die Kurzschlußpunkte 18 herum angedrückt, wie in vergrößerter Darstellung Figur 4 zeigt.

Der Kurzschlußrahmen besteht vorteilhafterweise aus einem Kunststoff mit antistatischen Eigenschaften, wie z. B. einem mit Kohlenstoffasern gefüllten Kunststoff, und/oder die leitenden Elemente 14, 15 sind zumindest auf ihrer Oberfläche metallisiert.

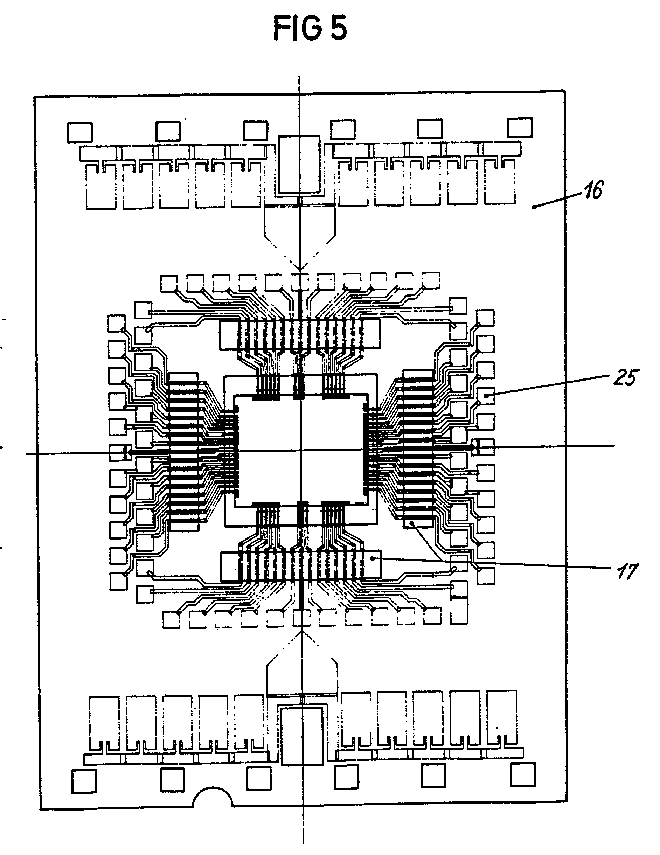

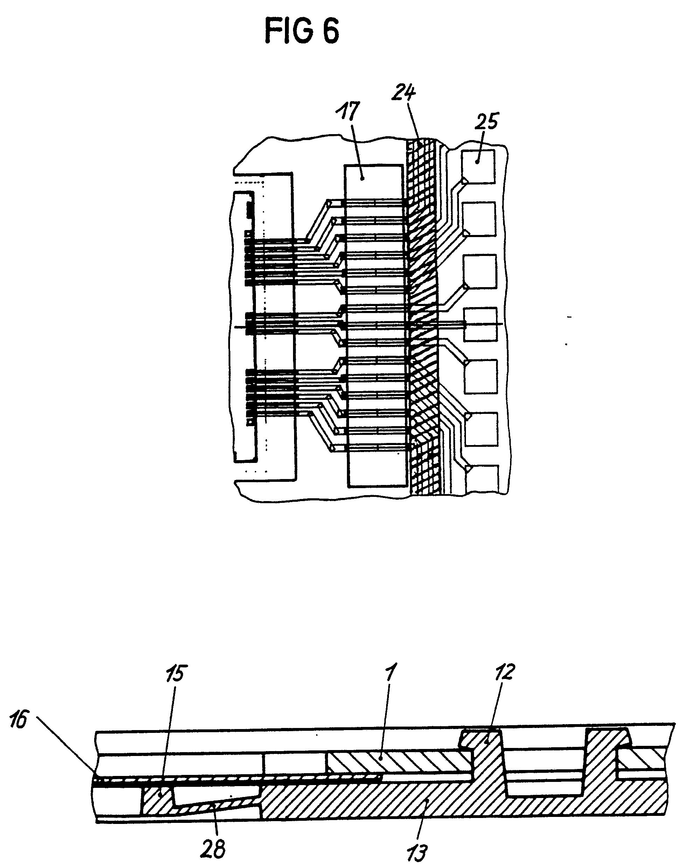

Figur 5 zeigt, das Beispiel eines filmmontierten integrierten Schaltkreises 16, bei dem im Gegensatz zum Ausführungsbeispiel von Figur 1 die äußeren Leiterbahnanschlüsse 17 bzw. die Prüfpunkte 25 nicht verlängert und in einem Kurzschlußpunkt zusammengefaßt bzw. über diesen geerdet sind. Wie auch derartige filmmontierte integrierte Schaltkreise mit der erfindungsgemäßen Vorrichtung sicher gegen elektrostatische Aufladungen gesichert werden können zeigt Figur 6. Der Kurzschlußrahmen 13 besitzt anstelle von ringförmigen leitenden Elementen leitende Elemente 15 in Form von Streifen oder Rahmen, die über Stege oder Membranen 28 mit dem Körper des Kurzschlußrahmens 13 verbunden sind. Diese streifen- oder rahmenförmigen leitenden Elemente 15 kommen im Falle eines Mikropacks 16 nach Figur 5 z. B. direkt über diejenigen äußeren Leiterbahnabschnitte zu liegen, die den äußeren Kontaktierbereich 17 mit den Prüfpunkten 25 verbinden, wie im oberen Teil von Figur 6 mit dem Bezugszeichen 24 angedeutet ist.

Die in den Figuren 2, 3, 4 und 6 gezeigten Ausführungsformen von Halterahmen 1 und Kurzschlußrahmen 2 sind lediglich als Beispiele angegeben worden und können ohne weiteres entsprechend der Form der zu schützenden filmmontierten Schaltkreise abgewandelt werden, ohne den Umfang der vorliegenden Erfindung zu verlassen.

**Patentansprüche**

1. Trägervorrichtung für filmmontierte integrierte Schaltkreise (Mikropacks) mit einem Halterahmen, der in seinen Außenabmessungen im wesentlichen den in der Fototechnik üblichen Diarahmen entspricht, mit einem im Inneren des Halterahmens vorgesehenen zentralen Fenster zum frei zugänglichen Lagern des filmmontierten integrierten Schaltkreises und mit mehreren an der Oberseite des Halterahmens verteilt angeordneten Haltenasen zum Eingreifen in eine Perforation des filmmontierten integrierten Schaltkreises und zum Fixieren von Lage und Planlage desselben im Halterahmen,

gekennzeichnet durch einen Kurzschlußrahmen (11, 13) mit verteilt angeordneten, beim Auflegen des Kurzschlußrahmens (11, 13) auf die Oberseite des Halterahmens (1) in zugeordnete Ausnehmungen (10) des Halterahmens (1) eingreifenden Verschließnoppen (12) und mit einem oder mehreren über Stege oder Membranen (28) mit dem Kurzschlußrahmen (11, 13) verbundenen leitenden Elementen (14, 15), die über äußeren Leiterbahnstrukturen des filmmontierten integrierten Schaltkreises (16) zu liegen kommen und über den Kurzschlußrahmen als flächige Kurzschlußbereiche verteilt angeordnet sind.

2. Trägervorrichtung nach Anspruch 1, dadurch gekennzeichnet, daß die leitenden Elemente (15) streifen- oder rahmenförmig ausgebildet sind.

3. Trägervorrichtung nach Anspruch 1, dadurch gekennzeichnet, daß für filmmontierte integrierte Schaltkreise (16), deren äußere Leiterbahnanschlüsse (17) über ihren jeweiligen Kontaktierbereich hinaus verlängert und in einem oder mehreren Kurzschlußpunkten (18) zusammengefaßt sind, die leitenden Elemente (14) ringförmig ausgebildet sind und über den eventuell vorher ausgestanzten Kurzschlußpunkten (18, 26) zu liegen kommen.

4. Trägervorrichtung nach einem der Ansprüche 1 bis 3, dadurch gekennzeichnet, daß der Kurzschlußrahmen (11, 13) aus einem Kunststoff mit antistatischen Eigenschaften besteht.

5. Trägervorrichtung nach einem der Ansprüche 1 bis 4, dadurch gekennzeichnet, daß zumindest die Oberfläche der über den kurzzuschließenden äußeren Leiterbahnanschlüssen (17) bzw. Kurzschlußpunkten (18) des Schaltkreises (16) zu liegen kommenden Elemente (14, 15) metallisiert ist.

6. Trägervorrichtung nach einem der Ansprüche 1 bis 5, gekennzeichnet durch Ausnehmungen (23) in dem Halterahmen (1) jeweils über den Kurzschlußpunkten des Schaltkreises (16) zum Ausstanzen derselben.

7. Verfahren zur Handhabung von filmmontierten integrierten Schaltkreisen unter Verwendung einer Trägervorrichtung nach den Ansprüchen 1 bis 6, bei dem die filmmontierten integrierten Schaltkreise jeweils nach ihrem Abtrennen vom Filmband in den Halterahmen eingelegt, dort fixiert und dann geprüft werden, dadurch gekennzeichnet, daß bei filmmontierten integrierten Schaltkreisen (16), deren äußere Leiterbahnanschlüsse über ihren jeweiligen Kontaktierbereich hinaus verlängern und in einem oder mehreren Kurzschlußpunkten zusammengefaßt sind, die Kurzschlußpunkte (18) nach Einlegen des filmmontierten integrierten Schaltkreises (16) in den Halterahmen (1) ausgestanzt werden und daß ein die äußeren Leiterbahnstrukturen des filmmontierten integrierten Schaltkreises kurzschließender Kurzschlußrahmen (11, 13) nach Prüfung des filmmontierten integrierten Schaltkreises (16) in den Halterahmen (1) eingelegt wird.

## Revendications

1. Dispositif de support pour des circuits intégrés montés sur pellicules (micropacks) comportant un cadre de retenue, dont les dimensions extérieures correspondent sensiblement aux cadres de diapositives, usuels dans la technique photographique, une fenêtre centrale prévue à l'intérieur du cadre de retenue, pour le montage, avec accès libre, du circuit intégré monté sur pellicule, et plusieurs ergots de retenue répartis sur la face supérieure du cadre de retenue et destinés à s'engager dans des perforations du circuit intégré monté sur pellicule et à fixer la position et la planéité de ce circuit dans le cadre de retenue, caractérisé par un cadre de court-circuit (11, 13) comportant des boutons de fermeture répartis (12), qui s'engagent dans des évidements associés (10) du cadre de retenue (1), lors de la mise en place du cadre de court-circuit (11, 13) sur la face supérieure du cadre de retenue (1), et un ou plusieurs éléments conducteurs (14, 15), qui sont reliés par l'intermédiaire de barrettes ou de membranes (28) au cadre de court-circuit (11, 13) qui viennent s'appliquer sur des structures extérieures d'une voie conductrice du circuit intégré (16) monté sur pellicule, pour un positionnement, à libre accessibilité du circuit intégré monté sur pellicule et qui sont répartis sur le cadre de court-circuit sous la forme de zones de court-circuit planes.

2. Dispositif de support suivant la revendication 1, caractérisé par le fait que les éléments conducteurs (15) sont réalisés en forme de bandes ou de cadres.

3. Dispositif de support suivant la revendication 1, caractérisé par le fait que pour des circuits intégrés (16) montés sur pellicules, dont les bornes extérieures (17) de la voie conductrice se prolongent au-delà des zones respectives des contacts de circuit et sont réunies en un ou plusieurs points de court-circuit (18), les éléments conducteurs (14) sont réalisés avec une forme annulaire et viennent s'appliquer au-dessus des points de court-circuit (18, 26) éventuellement préalablement éliminés par découpage.

4. Dispositif de support suivant l'une des revendications 1 à 3, caractérisé par le fait que le cadre de court-circuit (11, 13) est réalisé en une matière plastique possédant des propriétés antistatiques.

5. Dispositif de support suivant l'une des revendications 1 à 4, caractérisé par le fait qu'au moins la surface des éléments (14, 15), qui viennent s'appliquer au-dessus des bornes extérieures (17) de la voie conductrice ou des points de court-circuit (18), établissant un court-circuit, du circuit (16), est métallisée.

6. Dispositif de support suivant l'une des revendications 1 à 5, caractérisé par des évidements (23) ménagés dans le cadre de retenue (1) respectivement au-dessus des points de court-circuit du circuit (16), de manière à permettre l'élimination par découpage de ces points.

7. Procédé pour manipuler des circuits intégrés montés sur pellicules, moyennant l'utilisation d'un dispositif de support suivant les revendications 1 à 6, selon lequel on insère dans le cadre de support les circuits intégrés montés sur pellicules, respectivement après leur séparation de la bande en forme de pellicule, on les fixe dans ce cadre et on les teste alors, caractérisé en ce que, dans le cas de circuits intégrés (16) montés sur pellicules, dont les bornes extérieures de la voie conductrice se prolongent au-delà de la zone respective de contact de ces circuits et sont réunis en un ou plusieurs points de court-circuit, on retire par découpage les points de court-circuit (18) après l'insertion du circuit intégré (16) monté sur pellicule, dans le cadre de retenue (1), et qu'après contrôle du circuit intégré (16) monté sur pellicule, on insère dans le cadre de retenue (1) un cadre de court-circuit (11, 13) court-circuitant les structures extérieures de la voie conductrice du circuit intégré monté sur pellicule.

**Claims**

1. Carrier device for film-mounted integrated circuits (micropacks), having a holding frame, which essentially corresponds in its outer dimensions to the slide frames usual in photography, having a central window provided inside the holding frame for the freely accessible retention of the film-mounted integrated circuit, and having a plurality of holding tabs, distributedly arranged on the upper side of the holding frame, for engagement into a perforation of the film-mounted integrated circuit and for fixing of position and flatness of the same in the holding frame, characterized by a short-circuit frame (11, 13), having distributedly arranged wearing studs (12), engaging into assigned recesses (10) of the holding frame (1) when the short-circuit frame (11, 13) is placed on the upper side of the holding frame (1), and having one or more conducting elements (14, 15), which are connected to the short-circuit frame (11, 13) via webs or membranes (28), come to rest over outer conductor track structures of the film-mounted integrated circuit (16) and are distributedly arranged over the short-circuit frame as two-dimensioned short-circuiting areas.

2. Carrier device according to claim 1, characterized in that the conducting elements (15) are designed in the form of strips or frames.

3. Carrier device according to claim 1, characterized in that, for film-mounted integrated circuits (16), the outer conductor track terminals (17) of which are extended beyond their respective contacting region and are combined at one or more short-circuit points (18), the conducting elements (14) are designed in the form of rings and come to rest over any previously punched-out short-circuit points (18, 26) there may be.

4. Carrier device according to one of claims 1 to 3, characterized in that the short-circuit frame (11, 13) consists of a plastic with antistatic properties.

5. Carrier device according to one of claims 1 to 4, characterized in that at least the surface of the elements (14, 15) coming to rest over the outer conductor track terminals (17) to be shorted or short-circuit points (18) of the circuit (16) are metallized.

6. Carrier device according to one of claims 1 to 5, characterized by recesses (23) in the holding frame (1), in each case above the short-circuit points of the circuit (16), for punching-out of the same.

7. Method of handling film-mounted integrated circuits using a carrier device according to claims 1 to 6, in which the film-mounted integrated circuits are, after their separation from the tape, in each case inserted into the holding frame, fixed there and then tested, characterized in that, in the case of film-mounted integrated circuits (16) the outer conductor track terminals of which are extended beyond their respective contacting region and are combined at one or more short-circuit points, the short-circuit points (18) are punched out after insertion of the film-mounted integrated circuit (16) into the holding frame (1) and in that a short-circuit frame (11, 13), shorting the outer conductor track structures of the film-mounted integrated circuit, is inserted into the holding frame (1) after testing of the film-counted integrated circuit (16).

# FIG 1

# FIG 2

# FIG 3

FIG 4

# FIG 5

# FIG 6